# FASCICULE DE BREVET EUROPEEN

(11) **EP 3 704 504 B1**
(45) Date de publication et mention de la délivrance du brevet: **09.09.2026**
(21) Numéro de dépôt: 18738312.0
(22) Date de dépôt: 09.07.2018
(51) Int. Cl.: G01R 31/36, G01R 31/3835, G01R 31/396, G01R 31/58, G01R 31/66

(54) **PROCÉDÉ DE DÉTERMINATION DE L'ÉTAT D'UNE LIGNE ÉLECTRIQUE RELIANT UNE CELLULE DE BATTERIE D'ACCUMULATEURS À UNE UNITÉ DE CONTRÔLE ET UNITÉ DE CONTRÔLE CORRESPONDANTE**
VERFAHREN ZUR BESTIMMUNG DES ZUSTANDES EINER ELEKTRISCHEN LEITUNG, DIE EINE BATTERIEZELLE MIT EINER ÜBERWACHUNGSEINHEIT VERBINDET, UND ENTSPRECHENDE ÜBERWACHUNGSEINHEIT
METHOD FOR DETERMINING THE STATE OF AN ELECTRICAL LINE LINKING A BATTERY CELL TO A MONITORING UNIT, AND CORRESPONDING MONITORING UNIT

(30) Priorité: 04.09.2017 FR 1758138
(43) Date de publication de la demande: 09.09.2020
(73) Titulaire: Ampere SAS, 92100 Boulogne-Billancourt (FR); Nissan Motor Co., Ltd., Yokohama-shi, Kanagawa 221-0023 (JP)
(72) Inventeur: MALRIEU, Julien, 78280 Guyancourt (FR)
(74) Mandataire: Renault Group
(86) Numéro de dépôt international: PCT/EP2018/068565
(87) Numéro de publication internationale: WO 2019/042636

(56) Documents cités:
- WO-A1-98/48290
- JP-A- 2014 102 127
- US-A1- 2015 137 824
- US-A1- 2016 061 909

## Description

### DOMAINE TECHNIQUE AUQUEL SE RAPPORTE L'INVENTION

La présente invention concerne de manière générale le domaine des batteries d'accumulateurs.

Elle concerne plus particulièrement le domaine de la gestion électrique des cellules d'une batterie d'accumulateurs.

Elle concerne en particulier un procédé de détermination de l'état d'une ligne électrique reliant une cellule d'une batterie d'accumulateurs à une unité de contrôle de ladite batterie d'accumulateurs.

Elle concerne également un procédé d'alerte sur l'état de ladite ligne.

Elle concerne enfin une unité de contrôle des états de charge des cellules d'une batterie d'accumulateurs ainsi qu'un système pour véhicule automobile comportant une telle unité.

### ARRIERE-PLAN TECHNOLOGIQUE

La gestion des états de charge (« *States of Charge* » ou SoC en anglais) des cellules électro-chimiques d'une batterie d'accumulateurs, par exemple les batteries au lithium de type lithium-ion (« *Li-Ion »),* est rendue nécessaire afin de faire fonctionner ladite batterie dans son domaine de sécurité, en particulier pour éviter les sur-tensions ou sous-tensions aux bornes des cellules électriques.

Pour cela, la tension électrique entre les bornes positive et négative de chaque cellule doit être contrôlée régulièrement, que la batterie soit en état de charge ou de décharge, ou bien au repos (batterie plus ou moins chargée mais ne débitant aucun courant).

La mesure de la tension aux bornes desdites cellules est soumise à de fortes contraintes de sécurité (surveillance des sur-tensions ou sous-tensions) et de performance (précision de mesure de l'état de charge).

Généralement, le contrôle des cellules de la batterie se fait au moyen d'une unité électronique qui est reliée à chaque cellule par une ligne électrique, chaque ligne électrique comportant deux branches électriques reliant les deux bornes de chaque cellule à deux bornes d'entrée de l'unité électronique.

En particulier, on connaît des unités électroniques, dites d'équilibrage *(« battery management system »* ou *BMS* en anglais), qui permettent de faire fonctionner de manière optimale une batterie d'accumulateurs en égalisant les états de charge électrique de l'ensemble des cellules électriques d'une batterie d'accumulateurs, que la batterie fonctionne (en charge ou en décharge), ou non.

Lorsque les lignes électriques sont longues (par ex. : unité de contrôle implantée loin de la batterie) ou bien lorsque l'état de ces lignes (i.e. de ses branches électriques) peut se dégrader, il est nécessaire de déterminer la résistance de ligne de chaque ligne électrique.

Par *« résistance »* de ligne, on entend la partie réelle de l'impédance de la ligne électrique, cette impédance étant une grandeur complexe au sens mathématique du terme (i.e. avec une partie réelle et une partie imaginaire). La valeur de la résistance de ligne se mesure en ohms (symbole Ω).

Par exemple, une simple dégradation de contact au niveau du câblage entre l'une des branches électriques et l'une des bornes de la cellule peut impacter sérieusement à la hausse la résistance de la ligne de sorte que les mesures de tensions effectuées par l'unité de contrôle sont faussées.

En conséquence, si la ligne électrique est défaillante et présente par exemple une résistance de ligne trop importante, le pilotage de l'équilibrage des cellules peut conduire à un fonctionnement non optimal de la batterie, par exemple une diminution de son autonomie).

De plus, si les mesures de tensions effectuées par l'unité de contrôle sont faussées, alors les fonctions de diagnostic embarqué peuvent être également faussées, provoquant de fausses remontées de diagnostic vers l'unité électronique. Dans le cas d'un équilibrage actif des cellules, ceci pourrait par exemple entraîner une mauvaise compensation de tension d'équilibrage.

La solution au document US2016/061909A1 présente de tels inconvénients.

### OBJET DE L'INVENTION

Afin de remédier à l'inconvénient précité de l'état de la technique, la présente invention propose un procédé de détermination de l'état d'une ligne électrique permettant de détecter si l'une des lignes électriques est défaillante ou non.

Plus particulièrement, on propose selon l'invention un procédé de détermination de l'état d'une ligne électrique reliant une cellule d'une batterie d'accumulateurs à une unité de contrôle de ladite batterie d'accumulateurs, ladite ligne électrique comprenant une première branche électrique connectant une borne positive de ladite cellule à une première borne d'entrée de ladite unité de contrôle et une deuxième branche électrique connectant une borne négative de ladite cellule à une deuxième borne d'entrée de ladite unité de contrôle, ledit procédé comportant :
- une étape de calcul d'une valeur de résistance de ligne de ladite ligne électrique ; et
- une étape de détermination de l'état de ladite ligne électrique en fonction de ladite valeur de résistance de ligne calculée.

Ainsi, en déterminant, à chaque cycle d'utilisation de la batterie, l'état de la ligne électrique, on peut détecter si une ligne électrique (i.e. une cellule) est défaillante et doit être déconnectée pour préserver la sécurité et l'efficacité de fonctionnement de la batterie d'accumulateurs et pour désactiver les fonctions de diagnostic embarquées qui pourraient être impactées.

Au sens de l'invention, on entend que la résistance de ligne est la somme des résistances (i.e. des parties réelles des impédances) de la première branche électrique et de la deuxième branche électrique qui forment ladite ligne électrique.

Au sens de l'invention, ladite étape de calcul de la valeur de résistance de ligne comprend :
- une première sous-étape de mesure, à un premier instant de mesure lorsque ladite cellule de batterie d'accumulateurs n'est pas en charge ou en décharge, d'une première valeur de tension en circuit ouvert entre lesdites première et deuxième bornes d'entrée ;
- une sous-étape de fermeture au cours de laquelle l'unité de contrôle connecte lesdites première et deuxième bornes d'entrée par une branche électrique résistive dont la valeur de résistance électrique est prédéterminée ;
- une deuxième sous-étape de mesure, à un deuxième instant de mesure séparé dudit premier instant de mesure par une durée comprise entre une durée minimale et une durée maximale prédéterminées, d'une deuxième valeur de tension en circuit fermé entre lesdites première et deuxième bornes d'entrée ; et
- une sous-étape d'estimation de ladite valeur de résistance de ligne de ladite ligne électrique en fonction de ladite valeur de résistance électrique prédéterminée et desdites première et deuxième valeurs de tension mesurées.

Ainsi, grâce à l'unité de contrôle qui peut ouvrir et fermer le circuit électrique entre les deux bornes d'entrée associées à une cellule particulière, il est possible de faire deux mesures de tension à ces bornes d'entrée en circuit ouvert ou bien en circuit fermé sur une résistance connue, de sorte qu'on peut en déduire la valeur de la résistance de ligne de cette ligne électrique et déterminer l'état de celle-ci.

De préférence, lors de la sous-étape de fermeture (B2), chaque branche électrique résistive est une branche électrique d'équilibrage d'une cellule.

De préférence encore, ladite durée minimale est prédéterminée pour que ladite deuxième sous-étape de mesure soit réalisée en régime électrique statique.

Par régime électrique statique, on entend le régime électrique qui s'établit après un régime transitoire provoqué par des variations brutales de tensions ou de courants.

Afin de réaliser la deuxième sous-étape en régime électrique statique, on peut envisager de faire la mesure de tension en circuit fermé aux bornes d'entrée de l'unité de contrôle avec un appareil de mesure de tension ayant un filtre passe-bas en entrée, par exemple un simple circuit diviseur du premier ordre avec une résistance (de valeur R en ohms) et un condensateur (de capacité *C* en farads), dit *« filtre RC* », dont la fréquence de coupure (en hertz ou s⁻¹), notée *f_{c},* est égale à 1/(2*π*R*C).

En d'autres termes, on considérera que la deuxième sous-étape est réalisée en régime électrique statique si l'intervalle entre le premier instant et le deuxième instant de mesure est supérieur à 5 fois 2*π*R*C, soit 10*π*R*C. Au sens de l'invention, cet intervalle est de l'ordre de quelques millisecondes (ms), par exemple compris entre 1 et 100 ms, de préférence inférieur à 10 ms.

Au sens de l'invention, ladite durée maximale est prédéterminée de telle sorte que la valeur de tension entre lesdites bornes positive et négative de ladite cellule ne varie pas de plus de 1% en valeur absolue entre la première sous-étape de mesure et la deuxième sous-étape de mesure.

Dit autrement, la mesure de la tension en circuit fermé est réalisée suffisamment tôt pour que l'on puisse négliger la variation de la charge électrique entre les première et deuxième sous-étapes de mesure. De cette façon, la tension électrique entre les bornes positive et négative de la cellule considérée reste quasiment constante (à 1% près au maximum) entre les deux mesures.

Dans un mode de réalisation particulier, le procédé de détermination comporte une étape de comparaison de la valeur de résistance de ligne calculée avec une valeur seuil de résistance électrique, et à l'étape de détermination, l'état de ladite ligne électrique est déterminé en fonction du résultat de ladite comparaison.

En pratique, la ligne électrique reliant ladite cellule à l'unité de contrôle sera déterminée comme étant défaillante si la valeur de résistance de ligne calculée est supérieure à la valeur seuil de résistance électrique, qui est donc une valeur seuil maximale à ne pas dépasser.

À l'inverse, si la valeur de résistance de ligne calculée est inférieure à la valeur seuil de résistance électrique, alors cela signifie que ladite ligne électrique est correcte, en particulier que les branchements entre la cellule et l'unité sont peu impactants sur le processus de contrôle des cellules de la batterie.

Avantageusement, le procédé de détermination comporte en outre une étape de mesure d'une température représentative de la température environnant ladite ligne électrique, et ladite valeur seuil de résistance électrique est prédéterminée en fonction de cette température représentative.

Ceci permet d'améliorer la précision des mesures de tensions dans la mesure où, d'une part, la résistance de ligne recherchée, et, d'autre part, la résistance interne de la cellule considérée, varient en fonction de la température environnant la ligne électrique. Généralement, la variation d'une résistance interne d'une cellule est inversement proportionnelle à la variation de température, alors que la résistance de ligne a plutôt tendance à augmenter lorsque la température augmente.

En pratique, la température environnant la ligne électrique varie dans une plage de température où la résistance interne de chaque cellule est très inférieure à la résistance de ligne.

L'invention propose également un procédé de pilotage d'une cellule de batterie d'accumulateurs par une unité de contrôle, une ligne électrique reliant ladite cellule de batterie d'accumulateurs à ladite unité de contrôle de ladite batterie d'accumulateurs, ladite ligne électrique (201, 202, 203, 204, 205, 206) comprenant une première branche électrique connectant une borne positive de ladite cellule et une première borne d'entrée de ladite unité de contrôle et une deuxième branche électrique connectant une borne négative de ladite cellule et une deuxième borne d'entrée de ladite unité de contrôle, ledit procédé de pilotage comportant :
- une étape de détermination de l'état de ladite ligne électrique en utilisant un procédé de détermination tel que précité; et
- si la valeur de résistance de ligne de ladite ligne électrique est supérieure à ladite valeur seuil de résistance électrique, une étape de désactivation des fonctions de diagnostic impactées par le changement de la valeur de la résistance de ligne de ladite ligne électrique.

En effet, une valeur de résistance de ligne trop élevée peut être le signe d'un défaut de raccordement ou bien d'une dégradation de contact de ladite ligne électrique. Dans ce cas, lors de l'équilibrage de la cellule, il est probable que les mesures de tension aux bornes de cette cellule lorsque celle-ci fonctionnera seront faussées, conduisant alors à une mauvaise compensation d'erreur de mesure durant l'équilibrage des cellules ou une mauvaise remontée de diagnostics embarqués utilisant une fonction d'équilibrage de l'unité de contrôle.

Ce procédé de pilotage peut bien évidemment s'appliquer avantageusement à plusieurs ou à toutes les cellules de la batterie d'accumulateurs.

Si l'on détecte une défaillance sur la ligne électrique reliant une cellule de batterie d'accumulateurs à l'unité de contrôle, on peut également choisir de ne pas *« désactiver* » l'équilibrage de la cellule et d'avertir seulement un utilisateur de la batterie d'accumulateurs.

L'invention concerne ainsi un procédé d'alerte sur l'état d'une ligne électrique reliant une cellule d'une batterie d'accumulateurs à une unité de contrôle de ladite batterie d'accumulateurs, ladite ligne électrique comprenant une première branche électrique connectant une borne positive de ladite cellule à une première borne d'entrée de ladite unité de contrôle et une deuxième branche électrique connectant une borne négative de ladite cellule à une deuxième borne d'entrée de ladite unité de contrôle, ledit procédé d'alerte comportant :
- une étape de détermination de l'état de ladite ligne électrique en utilisant un procédé de détermination tel que précité; et
- une étape d'émission d'un signal d'alerte si la valeur de résistance de ligne est supérieure à ladite valeur seuil de résistance électrique.

L'invention propose par ailleurs une unité de contrôle des états de charge d'une pluralité de cellules d'une batterie d'accumulateurs, chaque cellule étant reliée à ladite unité de contrôle par une ligne électrique comprenant une première branche électrique connectant une borne positive de ladite cellule à une première borne d'entrée de ladite unité de contrôle et une deuxième branche électrique connectant une borne négative de ladite cellule à une deuxième borne d'entrée de ladite unité de contrôle, ladite unité de contrôle étant conçue pour :
- calculer une valeur de résistance de ligne de chaque ligne électrique ;
- déterminer l'état desdites lignes électriques en fonction desdites valeurs de résistance de ligne calculées.

L'unité de contrôle de l'invention peut par exemple comprendre un circuit électronique intégré dédié *(« application-specific standard product »* ou *ASSP* en anglais) spécialement conçu pour :
- mettre en circuit ouvert un circuit associé à chacune des cellules électriques de la batterie d'accumulateurs, en ouvrant le circuit entre chaque première et deuxième borne d'entrée associée à ladite cellule ;
- mettre en circuit fermé un circuit associé à chacune de ces mêmes cellules électriques de sorte que chaque première et deuxième borne d'entrée de l'unité sont reliées l'une à l'autre au travers d'une branche électrique purement résistive en régime stationnaire, la résistance de cette branche étant connue et fixée ;
- mesurer des valeurs de tension électrique entre chaque première borne d'entrée et chaque deuxième borne d'entrée, en circuit ouvert ou fermé selon les conditions décrites juste ci-dessus ; et
- calculer, en fonction des valeurs mesurées et de la connaissance préalable de la résistance connue, la résistance de ligne de chaque ligne électrique associée à une cellule de la batterie d'accumulateurs.

L'invention propose enfin un système pour véhicule automobile électrique ou hybride comportant :
- une batterie d'accumulateurs comprenant une pluralité de cellules électriques ; et
- une unité de contrôle telle que précitée.

L'invention propose également un véhicule automobile électrique ou hybride comportant :
- un système tel que précité ; et
- un moteur électrique alimenté en courant par ladite batterie d'accumulateurs dudit système.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique d'une batterie d'accumulateurs et d'une unité de contrôle de cette batterie ;
- la figure 2 est un schéma électrique équivalent en régime statique d'une cellule de la batterie de la figure 1 reliée à une carte de circuit imprimé de l'unité de la figure 1 ; et
- la figure 3 est un diagramme schématique d'un procédé de détermination conforme à l'invention.

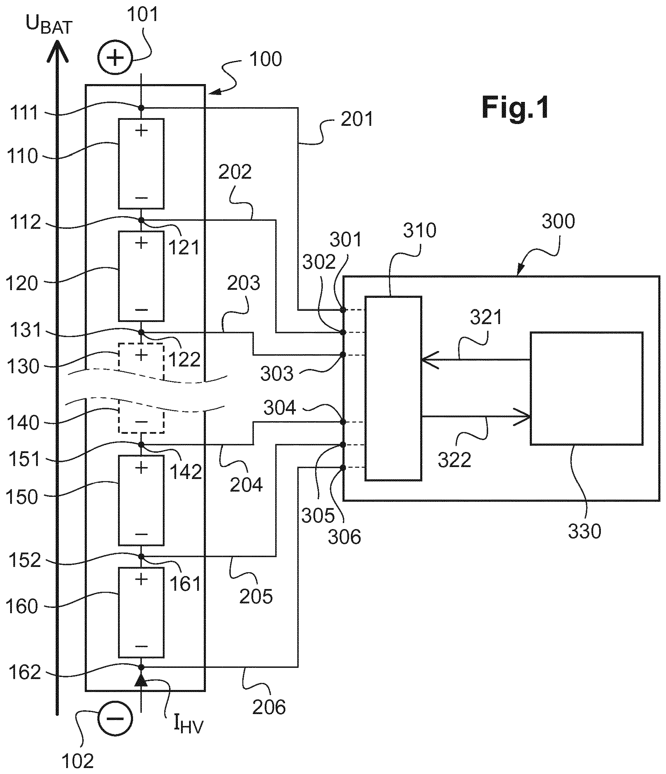

Afin de rendre la description plus concrète et plus facile à appréhender pour le lecteur, on décrira ci-après en référence aux figures 1 à 3 un exemple particulier de réalisation de l'invention dans le domaine automobile, en particulier pour la gestion électrique par une unité de contrôle 300 d'une batterie d'accumulateurs 100 (voir figure 1) équipant un véhicule automobile électrique ou hybride.

Toutefois, les procédés et produits de l'invention décrits ci-après ne sont nullement limités à ce type d'applications et pourraient tout aussi bien être mis en œuvre ou utilisés avec une batterie d'accumulateurs dans un autre domaine technique (par ex. : éclairage, alimentation électronique, chauffage ou climatisation, etc...).

Le véhicule automobile, qui n'a pas été ici représenté, comporte :
- un système comprenant ladite batterie d'accumulateurs 100 (désignée « *batterie 100 »* dans la suite de la description) et ladite unité de contrôle 300 de ladite batterie 100 adaptée à contrôler et à commander les états de charge d'une pluralité de cellules 110, 120, 130, 140, 150, 160 électriques de la batterie 100 ; et
- un moteur électrique conçu pour propulser ledit véhicule automobile lorsqu'il est alimenté en courant I_{HV} (voir fig. 1) par la batterie 100 dudit système et des moyens de recharge de la batterie 100.

Ces moyens de recharge de la batterie 100 comportent ici un simple chargeur électrique qui est adapté à être raccordé, d'un côté, aux bornes d'une prise électrique d'un réseau d'électricité domestique, et, de l'autre côté, aux bornes positive 101 et négative 102 de la batterie 100.

Alternativement, ou additionnellement, les moyens de recharge pourraient également comporter des moyens de freinage récupératifs, permettant de récupérer l'énergie générée par le freinage du véhicule automobile afin de recharger la batterie d'accumulateurs 10.

La batterie 100 est ici une batterie dite « *de traction* » destinée à alimenter en courant I_{HV} (voir fig. 1) le moteur électrique et divers organes auxiliaires connectés au réseau électrique du véhicule.

Elle comporte classiquement un boîtier de stockage (non représenté) duquel émergent la borne positive 101 et la borne négative 102.

Ce boitier de stockage loge la pluralité de cellules électriques 110, 120, 130, 140, 150, 160, dont les tensions nominales et le nombre sont calculés de telle sorte que le moteur électrique puisse développer un couple (mesuré en newtons mètre ou N.m) et/ou une puissance (mesurée en watts ou en chevaux-vapeurs) suffisants pour propulser le véhicule automobile pendant une durée ou sur une distance prédéterminée.

Typiquement, on utilisera de 100 à 200 cellules connectées de manière que la tension aux bornes positive 101 et négative 102 de la batterie 100 soit de l'ordre de 400 volts (V) et de capacité suffisante.

Chaque cellule présente habituellement une tension nominale à ses bornes de l'ordre de 2 à 5 V. Ici, les cellules 110, 120, 130, 140, 150, 160 sont de type lithium-ion (Li-Ion) et présentent chacune une tension nominale d'environ 3,7 V lorsqu'elles sont complètement chargées.

Ainsi, dans l'exemple de la figure 1, la batterie 100 comporte 108 cellules Li-Ion simples montées en série mais, pour la clarté des dessins, on a seulement représenté sur les figures six de ces cellules 110, 120, 130, 140, 150, 160 :
- les deux premières cellules 150, 160 : cellules de rang n°1 et n°2 ;
- les deux dernières cellules 110, 120 : cellules de rang n°107 et n°108 ; et
- les cellules 130, 140 : cellules de rang n°3 et n°106 (représentées partiellement en pointillés sur la figure 1).

En pratique, en début de cycle d'utilisation, les différentes cellules 110, 120, 130, 140, 150, 160 individuelles de la batterie 100 de traction ne présentent pas toutes les mêmes états de charge : on parle alors de « problème d'équilibrage des cellules ».

**Ceci est** dû au fait que les différentes cellules ne sont pas toutes rigoureusement identiques (leurs capacités et leurs résistances internes ne sont pas exactement égales à leur sortie d'usine), et n'évoluent pas de la même façon dans le temps, i.e. elles ne se déchargent pas toutes de la même façon (dispersion d'auto-décharge). De plus, les différentes cellules sont placées dans le boîtier de la batterie 100 en des zones plus ou moins bien refroidies ou ventilées, les températures environnantes de chaque cellule étant différentes.

Ainsi, certaines des cellules de la batterie de traction subissent des contraintes plus grandes que d'autres, ce qui réduit la capacité globale de la batterie de traction, ainsi que sa durée de vie.

Comme représentée sur la figure 1, chaque cellule 110, 120, 130, 140, 150, 160 de la batterie 100 comporte une borne positive 111, 121, 131, 151, 161 et une borne négative 112, 122, 142, 152, 162 (la borne négative de la cellule 130 et la borne positive de la cellule 140 ne sont pas visibles sur la figure 1).

Les cellules 110, 120, 130, 140, 150, 160 de la batterie 100 étant montées en série, la borne positive de la cellule de rang *n* (*n* = 1..N-1, avec ici N = 108), par exemple la borne 121 de la cellule 120 (de rang n°107) est commune avec la borne négative de la cellule adjacente de rang n+1, ici la borne négative 112 de la cellule 110 (de rang n°108).

De plus, la borne positive 111 de la cellule 110 (de rang n°108) est commune et électriquement connectée avec la borne positive 101 de la batterie 100. De la même manière, la borne négative 162 de la cellule 160 (de rang n°1) est commune et électriquement connectée avec la borne négative 102 de la batterie 100.

Afin de surveiller et d'égaliser les états de charge électrique de l'ensemble des cellules 110, 120, 130, 140, 150, 160 électriques de la batterie 100 d'accumulateurs, il est donc prévu une unité de contrôle 300 (désignée *« unité 300* » dans la suite de la description) de ces états de charge.

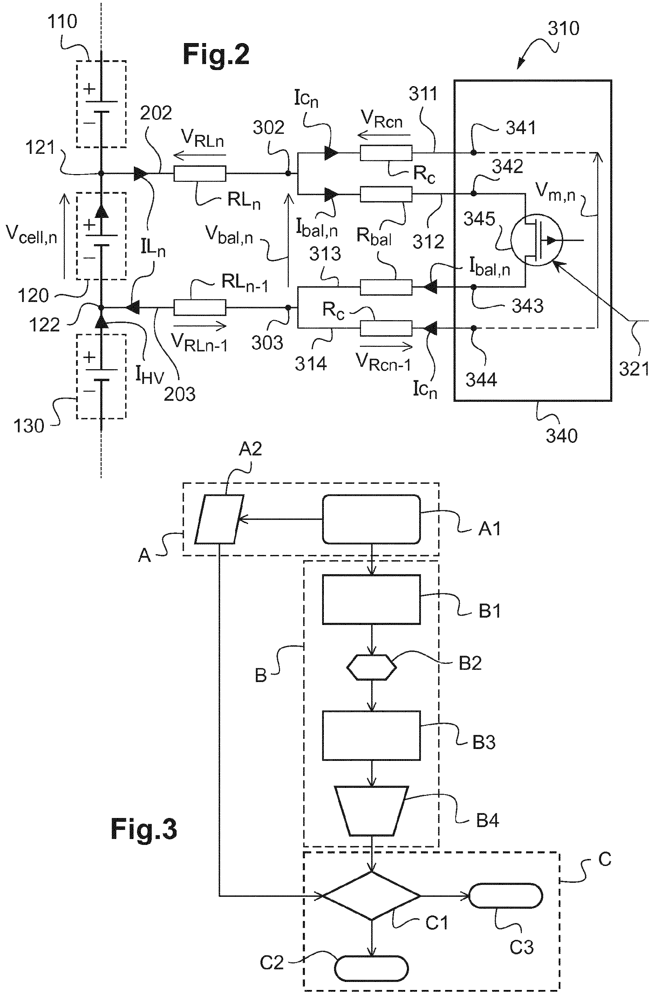

De manière générale, cette unité 300 fonctionne comme un système électronique de gestion de la batterie 100 (« *battery management system* » ou *BMS* en anglais) dont les fonctions principales sont de :
- déterminer les tensions électriques (notées ci-après V_{cell,1}, V_{cell,2}, ..., V_{cell,n}, , V_{cell,108} ; voir fig. 2 pour la tension V_{cell,n}) aux bornes des différentes cellules 110, 120, 130, 140, 150, 160 et/ou la tension totale U_{BAT} entre la borne positive 101 et la borne négative 102 de la batterie 100 ;
- déterminer indépendamment les états de charge (« *states of charge »* ou SoC en anglais) de chaque cellule 110, 120, 130, 140, 150, 160 ;
- déterminer le courant total I_{HV} débité par la batterie 100 en direction du moteur électrique ;
- déterminer une température moyenne T_{BAT} de la batterie 100 ou bien des températures individuelles T_{cell,n} (n = 1..N) de chacune des cellules 110, 120, 130, 140, 150, 160 de la batterie 100.

L'unité 300 permet également d'équilibrer les niveaux des capacités électriques de chaque cellule 110, 120, 130, 140, 150, 160.

L'équilibrage des cellules 110, 120, 130, 140, 150, 160 peut être actif ou passif.

Dans le cas de l'équilibrage *actif,* l'unité de contrôle prend une partie de l'énergie stockée par la cellule ou les cellules les plus chargées pour la donner à la ou aux cellules les moins chargées. Il y a donc un véritable transfert de charge effectif entre les différentes cellules électriques.

Dans le cas de l'équilibrage *passif,* l'unité de contrôle prend une partie de l'énergie stockée dans la ou les cellules les plus chargées pour la dissiper, généralement sous forme de chaleur. En pratique, la charge excédentaire des cellules les plus chargées est simplement évacuée par effet Joule dans des résistances électriques de l'unité.

Ici, sans que cela soit limitatif, on se placera dans le cas d'une unité 300 destinée à réaliser l'équilibrage passif des cellules 110, 120, 130, 140, 150, 160 de la batterie 100. On détaillera dans la suite de la description quels sont les moyens mis en œuvre au sein de l'unité 300 pour réaliser cet équilibrage de cellules.

Afin que l'unité 300 puisse réaliser l'équilibrage des états de charge électrique des cellules 110, 120, 130, 140, 150, 160, chaque cellule 110, 120, 130, 140, 150, 160 de la batterie 100 est reliée à l'unité 300 par une ligne électrique.

Par « *cellule reliée* à l'unité 300 *par une ligne électrique »,* on comprend à la lumière de la figure 1 que chaque ligne électrique peut se diviser en :
- une première branche électrique 201, 202, 203, 204, 205 connectant la borne positive 111, 121, 131, 151, 161 de la cellule 110, 120, 130, 150, 160 considérée à une première borne d'entrée 301, 302, 303, 304, 305 de l'unité 300 ; et
- une deuxième branche électrique 202, 203, 204, 205, 206 connectant la borne négative 112, 122, 142, 152, 162 de la cellule 110, 120, 140, 150, 160 considérée à une deuxième borne d'entrée 302, 303, 304, 305, 306 de l'unité 300.

Comme pour les bornes des cellules 110, 120, 130, 140, 150, 160, on remarquera que la première branche électrique reliant une cellule de rang *n* à l'unité 300 est également la deuxième branche électrique reliant la cellule adjacente supérieure (de rang *n*+1) à l'unité 300.

Par exemple, la première branche 202 de la 107^{ème} ligne électrique qui connecte la borne positive 121 de la cellule 120 (de rang n°107) à l'unité 300 est également la deuxième branche électrique (référencée également 202) de la 108^{ème} ligne électrique qui connecte la borne négative 112 (borne commune avec la cellule 120) de la cellule 110 (de rang n°108).

Il y a donc autant de lignes électriques que de cellules électriques et chaque ligne électrique (dite « de rang *n* » par la suite) est associée à une cellule électrique (de rang n) particulière.

En d'autres termes, deux lignes électriques adjacentes associées à deux cellules adjacentes de rangs voisins (*n et n+1* ou *n et n-1* par exemple) ayant une borne (positive ou négative) en commun partage ensemble une (première ou deuxième) branche électrique qui connecte ladite borne commune à une (première ou deuxième) borne d'entrée de l'unité 300.

On observera que les *« lignes électriques* » décrites ici sont pour le moins fictives, en ce sens qu'elles ne se résument pas (comme pourrait le laisser croire la figure 1) chacune à un simple fil électrique reliant les bornes positive et négative d'une cellule de batterie à deux bornes d'entrée de l'unité de contrôle.

En effet, on entend plutôt ici par « *ligne électrique »,* tout moyen électrique permettant la circulation et l'acheminement d'un courant électrique entre l'unité 300 et la cellule 110, 120, 130, 140, 150, 160 associée à cette ligne.

Une ligne électrique au sens de l'invention est donc plutôt un modèle électrique destiné à rendre compte de l'existence de câbles, fils, raccords, connecteurs, fusibles, soudures, ou pistes conductrices entre une cellule 110, 120, 130, 140, 150, 160 et l'unité 300.

Chaque ligne électrique présente un état qui est susceptible d'évoluer dans le temps et d'affecter les résultats des mesures effectuées par l'unité 300 (et donc d'affecter également le processus d'équilibrage des cellules).

Selon l'invention, cet état est évalué à l'aide d'un paramètre appelé « résistance de ligne », et qui correspond globalement à la résistance électrique de la ligne électrique considérée.

Afin de mieux comprendre comment on peut calculer les valeurs de résistance de ligne, on a représenté sur la figure 2, le schéma électrique équivalent en régime statique de la *n-ième* cellule électrique 120 (ici cellule de rang *n* = 107) connectée à l'unité 300 par la *n-ième* ligne électrique (ligne de rang *n*), qui comprend la première branche électrique 202 entre la borne positive 121 de la cellule 120 et la borne d'entrée 302 de l'unité 300 et la deuxième branche électrique 203 entre la borne négative 122 de la cellule 120 et la borne d'entrée 303 de l'unité 300.

En régime statique, la ligne électrique de rang *n* est ainsi modélisée par (voir figure 2 pour la ligne de rang n°107) :
- une résistance électrique équivalente RLₙ sur la première branche 202 de ladite ligne électrique ; et
- une résistance électrique équivalente RLₙ₋₁ sur la deuxième branche 203 de ladite ligne électrique.

Comme représentée sur la figure 1, l'unité 300 comporte ici un microcontrôleur 330 destinée à interagir avec une carte 310 de circuit imprimé au moyen de deux bus électriques :
- un premier bus 321 électrique allant du microcontrôleur 330 vers la carte 310 ; et
- un deuxième bus 322 électrique allant de la carte 310 vers le microcontrôleur 330.

Ce microcontrôleur 330 peut avantageusement être l'unité de contrôle électronique (i.e. l'ordinateur de bord) du véhicule automobile et comporter :
- un microprocesseur (CPU) ;
- une mémoire vive (RAM) ;
- une mémoire morte (ROM) ;
- des convertisseurs analogiques-numériques (ADC) ou des convertisseurs numériques-analogiques (DAC) ; et
- différentes interfaces d'entrée et de sortie.

Le micro-processeur est apte à exécuter différents programmes mémorisés dans la mémoire morte.

Les interfaces d'entrées quant à elles permettent au microcontrôleur 330 d'acquérir des données relatives au moteur électrique, au chargeur et aux cellules 110, 120, 130, 140, 150, 160 de la batterie 100 de traction *via* le deuxième bus 322 notamment, en vue de les stocker dans la mémoire vive.

Les interfaces de sortie permettent au microcontrôleur 330 de piloter, *via* le premier bus 321, un circuit intégré 340 (voir figure 2) de la carte 310 de circuit imprimé.

Ce circuit intégré 340 est destiné à mesurer les tensions V_{m,n} (voir fig. 2) entre :
- une première broche de mesure 341 du circuit intégré 340 raccordée *via* une résistance de charge Rc (tension V_{Rc,n}, courant Icₙ) à la première borne d'entrée 302 de l'unité 300 ; et
- une deuxième broche de mesure 344 du circuit intégré 340 raccordée *via* une résistance de charge Rc (tension V_{Rc,n-1}, courant Icₙ₋₁) à la deuxième borne d'entrée 303 de l'unité 300.

Ces deux broches de mesure 341, 344 sont donc associées, au travers des résistances de charge, à une ligne électrique 202, 203 reliant une cellule 120 de la batterie 100 à l'unité 300.

Le circuit intégré 340 peut être par exemple un circuit intégré commercialisé par la société Maxim Integrated dans la gamme de produits MAX17823 ou MAX1785x, ou bien tout autre circuit ASSP suivant la même architecture.

Par ailleurs, le circuit intégré 340 possède, pour chaque ligne électrique 202, 203, un transistor 345 (voir fig. 2), qui est piloté par le micro-contrôleur 330 via le premier bus 321 (cf. flèche pointant sur le transistor 345 de la figure 2) et qui est connecté entre une première broche d'équilibrage 342 et une deuxième broche d'équilibrage 343 et présentant en régime statique :
- un état passant dans lequel il est équivalent à une résistance R_{sw} ; et
- un état bloquant dans lequel il est équivalent à un circuit ouvert (courant nul entre les deux broches d'équilibrage).

Le micro-contrôleur 330 est également programmé pour maintenir, *via* la carte 310 de circuit imprimé, les états de charge des différentes cellules 110, 120, 130, 140, 150, 160 au même niveau, afin d'éviter tout déséquilibre entre les cellules 110, 120, 130, 140, 150, 160 qui serait néfaste à la durée de vie de la batterie 100 et pour l'autonomie du véhicule.

Pour cela, le micro-contrôleur 330 pilote, en fonction des tensions V_{m,1}, V_{m,2}, ..., V_{m,n}, ..., V_{m,N} mesurées entre chaque paire de broches de mesure, les transistors (par ex. le transistor 345) associés aux lignes électriques (par ex. la ligne électrique formée des deux branches 202, 203) pour :
- mettre un ou plusieurs transistors dans l'état bloquant : équilibrage désactivé (équilibrage « OFF ») pour ces transistors ;
- mettre un ou plusieurs transistors dans l'état passant : équilibrage activé (équilibrage « ON ») pour ces transistors.

Lorsque l'équilibrage est activé pour une cellule 120, i.e. pour une ligne électrique (par ex. pour la ligne électrique 202, 203 de la figure 2), une partie de la charge de la cellule (ici la cellule 120 de la figure 2) est dissipée, entre les deux bornes d'entrée 302, 303 de l'unité 300, au travers de deux résistances électriques d'équilibrage R_{bal} (qui sont ici égales mais qui pourraient être différentes) placées chacune sur une branche d'équilibrage 312, 313, entre la première borne d'entrée 302 et la première broche d'équilibrage 342, et entre la deuxième borne d'entrée 303 et la deuxième broche d'équilibrage 343.

L'un des objectifs de l'invention est de déterminer la résistance électrique (en ohms) de chaque ligne électrique du système, ci-après désignée *« résistance de ligne* » et notée R_{I,1}, R_{I,2}, ..., R_{I,n}, ..., R_{I,N}.

Cette détermination des résistances de ligne des lignes électriques reliant les cellules 110, 120, 130, 140, 150, 160 à l'unité 300 peut avantageusement être utilisée afin de déclencher une alerte si la valeur mesurée est trop importante par rapport à un seuil calibrable.

Cette détermination peut également servir pour désactiver les diagnostics utilisant la fonction d'équilibrage dans leur surveillance qui seraient mis en défaut.

La détermination des résistances de ligne R_{I,1}, R_{I,2}, ..., R_{I,n}, ..., R_{I,N} permet également de corriger les valeurs V_{cell,1}, V_{cell,2}, ..., V_{cell,n},..., V_{cell,N} de tension électrique aux bornes des cellules 110, 120, 130, 140, 150, 160 qui sont mesurées par l'unité 300 lors de la charge ou de la décharge d'une ou plusieurs cellules 110, 120, 130, 140, 150, 160 de la batterie 100.

La valeur de la résistance de ligne peut en outre servir comme valeur de référence en début de cycle d'utilisation de la batterie afin de recaler les modèles de compensation d'équilibrage de tension lorsqu'on utilise cette méthode. En effet, en cycle nominal d'utilisation, si l'on choisit d'activer l'équilibrage en même temps que la mesure de tension, les chutes de tensions le long des lignes électriques ne sont pas négligeables vis-à-vis des précisions de mesure de la tension aux bornes des cellules et nécessitent d'être compensées. Pour cela, il faut connaître précisément les valeurs de résistance de ligne de chaque ligne afin de reconstruire ces tensions.

Chaque ligne électrique étant formée de deux branches électriques 201, 202, 203, 204, 205, 206, la valeur R_{I,n} de résistance de ligne de la ligne électrique de rang *n* est égale à la résistance , soit : R_{I,n} = RLₙ + RLₙ₋₁.

On va maintenant présenter en référence à la figure 3 un procédé de détermination permettant de déterminer justement les valeurs des résistances de ligne en question, et d'en déduire l'état de chaque ligne électrique.

Ce procédé est mis en œuvre par l'unité 300, et plus précisément par le micro-contrôleur 330 de ladite unité 300.

Cette unité 300 de contrôle est ainsi conçue pour :
- calculer une valeur R_{I,n} de résistance de ligne de chaque ligne électrique 201-202, 202-203, 204-205, 205-206 ; et
- déterminer l'état desdites lignes électriques 201-202, 202-203, 204-205, 205-206 en fonction desdites valeurs R_{I,n} de résistance de ligne calculées.

Selon l'invention, pour déterminer l'état d'une ligne électrique, ledit procédé comporte :
- une étape de calcul (bloc B de la figure 3) d'une valeur de résistance de ligne de ladite ligne électrique ; et
- une étape de détermination (bloc C de la figure 3) de l'état de ladite ligne électrique en fonction de cette valeur de résistance de ligne calculée.

Pour la suite de la description, afin d'illustrer le procédé de l'invention, on particularisera la description à la détermination de l'état de la ligne électrique de rang n (formée par les branches électriques 202 et 203 entre les bornes 121 et 302 et entre les bornes 122 et 303) telle que représentée sur la figure 2 (valeur R_{I,n} = RLₙ + RLₙ₋₁ de la résistance de ligne, transistor 345 piloté par le micro-contrôleur 330 de l'unité 300).

Avantageusement, le procédé comporte en outre une étape de mesure (sous-bloc A1 du bloc A de la figure 3) des températures TL₁, TL₂, ..., TLₙ, ..., TL_{N} (ci-après désignées *« températures de ligne* ») représentatives de la température environnant les lignes électriques 201-202, 202-203, 204-205, 205-206.

En effet, dans tout système électrique, les valeurs de résistances électriques sont fortement dépendantes de la température et il est judicieux de rattacher la mesure d'une résistance de ligne à une valeur de température environnante.

Les valeurs TL₁, TL₂, ..., TLₙ, ..., TL_{N} de température de ligne sont transférées et stockées dans la mémoire vive du micro-contrôleur 330 de l'unité 300.

Si l'une des valeurs TL₁, TL₂, ..., TLₙ, ..., TL_{N} de température de ligne est inférieure à une valeur seuil de température TLₘᵢₙ, alors dans les calculs qui suivent il est nécessaire de tenir compte de la résistance interne de la cellule correspondante.

Selon un mode de réalisation préféré, la valeur R_{I,n} de résistance de ligne est calculée en effectuant une première mesure sans équilibrage (équilibrage OFF, transistor 345 bloquant : I_{bal,n} = 0 A) puis une deuxième mesure avec équilibrage (équilibrage ON, transistor 345 passant : I_{bal,n} > 0 A) de la tension électrique V_{bal,n} (voir fig. 2) entre chaque paire de première et deuxième borne d'entrée 302, 303 de l'unité 300.

Plus précisément, selon ce mode de réalisation particulier du procédé de détermination de l'invention, l'étape de calcul (bloc B de la figure 3) de la valeur R_{I,n} de résistance de ligne comprend :
- une première sous-étape de mesure (sous-bloc B1), lorsque la cellule 120 de batterie 100 n'est pas en charge ou en décharge, d'une première valeur V_{m1,n} de tension en circuit ouvert entre la première borne d'entrée 302 et la deuxième borne d'entrée 303 ;
- une sous-étape de fermeture (sous-bloc B2) à un premier instant t_{1,} lors de laquelle l'unité 300 connecte la première borne d'entrée 302 et la deuxième borne d'entrée 303 par une branche électrique résistive (ici formées par les branches d'équilibrage 312, 313 et par la branche passante 342-343 du transistor 345) dont la valeur R_{bal,n} de résistance électrique est prédéterminée ;
- une deuxième sous-étape de mesure (sous-bloc B3), à un deuxième instant de mesure t₂ séparé dudit premier instant de mesure t₁ par une durée Δt comprise entre une durée minimale Δtₘᵢₙ et une durée maximale Δtₘₐₓ prédéterminées, d'une deuxième valeur V_{m2,n} de tension en circuit fermé entre la première borne d'entrée 302 et la deuxième borne d'entrée 303 ; et
- une sous-étape d'estimation (sous-bloc B4) de la valeur R_{I,n} de résistance de ligne de cette ligne électrique 202, 203 en fonction de ladite valeur R_{bal,n} de résistance électrique prédéterminée et des première et deuxième valeurs V_{m1,n}, V_{m2,n} de tension mesurées.

Nous allons maintenant détailler comment, en pratique, il est possible d'estimer cette valeur R_{I,n} de résistance de ligne à la sous-étape B4, à partir des mesures des sous-étapes B1 et B3.

### Sous-étape B1

Lors de cette première sous-étape de mesure, on suppose que l'on est en régime statique et que les relais de puissance de la batterie 10 sont encore ouverts, ce qui garantit une valeur U_{BAT} de tension à vide de la batterie 10 et un courant débité I_{HV} égal à 0 ampère.

De plus, lors de cette sous-étape B1, le transistor 345 de l'unité 300 est commandé par le micro-contrôleur 330 pour être en mode bloquant (équilibrage OFF), de sorte que le circuit électrique entre les deux broches d'équilibrage 342, 343 est ouvert : I_{bal,n} = 0 et Icₙ = ILₙ.

On supposera dans la suite que la résistance d'entrée entre les deux broches de mesure 341, 344 est très élevée, *i.e. quasi* infinie par rapport aux deux résistances de charge Rc des deux branches de mesure 311, 314.

Ainsi, lorsque l'équilibrage est désactivé (I_{bal,n} = 0), on a la relation : ILₙ = Icₙ ≈ 0 A.

En pratique, les valeurs Rc de résistance de charge sont de l'ordre de 1 à 2 kΩ et Icₙ est inférieur ou égal à 1 µA (fixé par le circuit intégré 340 et généralement autour de 200 nA), de sorte que l'erreur de mesure sur la tension V_{bal,n} due au courant traversant les résistances de charge est négligeable par rapport à la valeur V_{m1,n} de tension entre les deux broches de mesure 341, 344.

De cette façon, on peut écrire : V_{cell,n} = V_{bal,n} (car ILₙ ≈ 0 et résistance interne de la cellule très faible) et V_{bal,n} ≈ V_{m1,n} (car Icₙ ≈ 0), d'où V_{m1,n} ≈ V_{cell,n}.

### Sous-étape B2

À un premier instant, noté ci-après t₁, l'unité 300 enclenche l'équilibrage de la cellule 120 de rang *n* (n = 107) de sorte que le transistor 345 du circuit imprimé 340 devient passant et équivalent à une résistance électrique de valeur R_{sw,n}. (on pourra supposer pour la suite que tous les transistors du circuit imprimé 340 placés entre deux bornes d'équilibrage sont identiques et de même résistance R_{sw}). La valeur R_{bal,n} de résistance électrique de la branche électrique reliant les deux bornes d'entrée 302, 303 de l'unité 300 est alors telle que : R_{bal,n} = 2 R_{bal} + R_{sw}. On attend alors jusqu'au deuxième instant t₂ avant la prochaine étape B3.

### Sous-étape B3

Le deuxième instant t₂ est choisi de sorte que l'intervalle de temps Δt = t₂-t₁ entre le premier instant t₁ et le deuxième instant t₂ soit compris entre un intervalle minimum Δtₘᵢₙ et un intervalle maximum Δtₘₐₓ prédéterminés, respectivement de préférence tels que :
- la deuxième sous-étape de mesure B3 soit réalisée en régime électrique statique : t₂ suffisamment éloigné de t₁ pour être en régime statique ; et
- la valeur V_{cell,n} de la tension entre les bornes positive et négative 121, 122 de la cellule 120 ne varie pas de plus de 1% en valeur absolue entre la première et la deuxième sous-étape B1, B3 de mesure : t₂ pas trop éloigné de t₁ pour pouvoir négliger (à 1% près) la variation de tension aux bornes de la cellule 120.

En pratique, le régime statique est atteint après quelques dizaines de millisecondes, soit Δtₘᵢₙ = de 10 à 50 ms ; et la valeur V_{cell,n} de la tension de cellule ne commence à chuter qu'après quelques minutes, soit Δtₘₐₓ = de 1 à 3 minutes.

Une fois le transistor 345 mis en mode passant et le régime statique établi, on mesure au deuxième instant t₂ la tension V_{m2,n} entre les deux broches de mesure 341, 344 du circuit intégré 340.

### Sous-étape B4

À l'issue des deux sous-étapes de mesure B1 et B3, on connaît les valeurs V_{m1,n} et V_{m2,n} entre les deux broches de mesure 341, 344 du circuit intégré 340, lorsque l'équilibrage est désactivé (I_{bal,n} = 0 A) et lorsqu'il est activé (I_{bal,n} > 0 A).

Ces deux valeurs sont transmises *via* le deuxième bus 322 de l'unité 300 au micro-contrôleur 330 qui va calculer grâce à elles la valeur R_{I,n} de résistance de ligne.

On a les relations suivantes pour les valeurs de tension électrique de la figure 2 :
(a) ${V}_{cell , n} = {V}_{bal , n} + {V}_{RLn} + {V}_{RLn - 1} = {V}_{bal , n} + \left({RL}_{n}+{RL}_{n - 1}\right) * {IL}_{n} = {V}_{bal , n} + {R}_{l , n} * {IL}_{n}$
(b) ${V}_{m 2 , n} \approx {V}_{bal , n}$
(c) ${V}_{bal , n} = {R}_{bal , n} * {I}_{bal , n} = \left(2*{R}_{bal}+{R}_{sw , n}\right) * {I}_{Ln}$

En combinant les trois relations (a), (b), et (c) ci-dessus avec la relation V_{m1,n} = V_{cell,n} (voir sous-étape B1 ci-dessus), on obtient alors R_{I,n} ≈ (V_{m1,n} - V_{m2,n})/ILₙ, soit encore : R_{I,n} ≈ (2*R_{bal} + Rs_{w,n})*[(V_{m1,n}/V_{m2,n}) - 1].

Le micro-contrôleur 330 utilise la formule précédente pour estimer la résistance de ligne. Le micro-processeur du micro-contrôleur 330 est programmé pour effectuer le calcul selon la formule précédente pour toutes les lignes électriques.

Avantageusement, le micro-contrôleur 330 est programmé pour, dans une première phase, piloter uniquement les transistors du circuit intégré 340 associés à une ligne électrique de rang impair pour calculer la résistance de ligne de ces lignes de rang impair ; les transistors associés aux lignes électriques de rang pair étant maintenus à l'état bloquant. Ceci permet de réaliser des mesures découplées sur les cellules de rang impair et les cellules de rang pair.

Dans cette première phase, seules les valeurs R_{I,n} (avec *n=2*k+1,* k=0, 1, 2, ..., Ent(N/2)-1) des résistances de ligne des lignes électriques de rang impair sont donc calculées.

Dans une deuxième phase, le micro-contrôleur 330 est programmé pour piloter les transistors du circuit intégré 340 associés aux lignes électriques de rang pair pour calculer les valeurs de la résistance de ligne de ces lignes de rang pair.

À l'issue de l'étape B de calcul, l'unité 300 possède dans la mémoire vive du micro-contrôleur 330 :
- les valeurs TL₁, TL₂,..., TLₙ,..., TL_{N} de la température représentative de chaque ligne électrique ; et
- les valeurs R_{I,1}, R_{I,2},..., R_{I,n},..., R_{I,N} de la résistance de ligne de chaque ligne électrique.

Lors de l'étape C de détermination (voir figure 3), on détermine l'état de chaque ligne électrique en fonction des valeurs R_{I,1}, R_{I,2},..., R_{I,n},..., R_{I,N} de la résistance de ligne de chaque ligne électrique.

Dans un mode de réalisation préféré, l'étape C de détermination comporte une sous-étape de comparaison (sous-bloc C1 de la figure 3), lors de laquelle l'unité 300, et plus précisément le micro-processeur du micro-contrôleur 330, compare la valeur R_{I,n} de résistance électrique de chaque ligne électrique avec une valeur seuil RLₘₐₓ de résistance électrique prédéterminée.

De préférence, la valeur seuil RL_{max,n} de résistance électrique de la ligne électrique de rang *n* est prédéterminée (sous-bloc A2 du bloc A de la figure 1) en fonction de la température TLₙ représentative de cette ligne électrique.

Si la comparaison précédente montre que la valeur R_{I,n} de résistance de ligne de la ligne électrique de rang *n* est inférieure à la valeur seuil RL_{max,n} (cas du sous-bloc C2 de la figure 3), alors l'unité 300 considère que la ligne électrique de rang *n* présente un état normal de fonctionnement.

À l'inverse, si la comparaison précédente montre que la valeur R_{I,n} de résistance de ligne de la ligne électrique de rang *n* est supérieure à la valeur seuil RL_{max,n} (cas du sous-bloc C3 de la figure 3), alors l'unité 300 considère que la ligne électrique de rang *n* présente un état anormal de fonctionnement et qu'un défaut d'impédance de ligne a été détectée sur cette ligne électrique de rang *n*.

Dans ce cas, on peut prévoir que l'unité 300 pilote le circuit intégré 340 de manière à désactiver les fonctions de diagnostic impactées par le changement de la valeur de la résistance de ligne de la ligne électrique défectueuse.

On peut également prévoir d'émettre un signal d'alerte si la valeur R_{I,n} de résistance de ligne est supérieure à ladite valeur seuil RL_{max,n} de résistance électrique pour la température TLₙ considérée

## Revendications

1. Procédé de détermination de l'état d'une ligne électrique reliant une cellule (110, 120, 130, 140, 150, 160) d'une batterie d'accumulateurs (100) à une unité de contrôle (300) de ladite batterie d'accumulateurs (100), ladite ligne électrique comprenant une première branche électrique (201, 202, 203, 204, 205) connectant une borne positive (111, 121, 131, 151, 161) de ladite cellule (110, 120, 130, 150, 160) à une première borne d'entrée (301, 302, 303, 304, 305) de ladite unité de contrôle (300) et une deuxième branche électrique (202, 203, 204, 205, 206) connectant une borne négative (112, 122, 142, 152, 162) de ladite cellule (110, 120, 140, 150, 160) à une deuxième borne d'entrée (302, 303, 304, 305, 306) de ladite unité de contrôle (300), ledit procédé comportant :
- une étape de calcul (B) d'une valeur (R_{I,n}) de résistance de ligne de ladite ligne électrique (201, 202, 203, 204, 205, 206) comprenant :
- une première sous-étape de mesure (B1), lorsque ladite cellule de batterie d'accumulateurs (100) n'est pas en charge ou en décharge, d'une première valeur (V_{m1,n}) de tension en circuit ouvert entre lesdites première et deuxième bornes d'entrée (301, 302, 303, 304, 305, 306) ;
- une sous-étape de fermeture (B2), à un premier instant (t₁), au cours de laquelle l'unité de contrôle (300) connecte lesdites première et deuxième bornes d'entrée (301, 302, 303, 304, 305, 306) par une branche électrique résistive (312, 313, 342343) dont la valeur (R_{bal,n}) de résistance électrique est prédéterminée ;
- une deuxième sous-étape de mesure (B3), à un deuxième instant (t₂) séparé dudit premier instant (t₁) par une durée (Δt) comprise entre une durée minimale (Δtₘᵢₙ) et une durée maximale (Δtₘₐₓ) prédéterminées, d'une deuxième valeur (V_{m2,n}) de tension en circuit fermé entre lesdites première et deuxième bornes d'entrée (301, 302, 303, 304, 305, 306) ; et
- une sous-étape d'estimation (B4) de ladite valeur (R_{I,n}) de résistance de ligne de ladite ligne électrique (201, 202, 203, 204, 205, 206) en fonction de ladite valeur (R_{bal,n}) de résistance électrique prédéterminée et desdites première et deuxième valeurs (V_{m1,n}, V_{m2,n}) de tension mesurées ; et
- une étape de détermination (C) de l'état de ladite ligne électrique (201, 202, 203, 204, 205, 206) en fonction de ladite valeur (R_{I,n}) de résistance de ligne calculée,
ledit procédé de détermination étant **caractérisé en ce que** :
- ladite durée minimale (Δtₘᵢₙ) est prédéterminée pour que ladite deuxième sous-étape de mesure (B3) soit réalisée en régime électrique statique, comprise entre 1 et 100 ms, de préférence inférieure à 10 ms ; et
- ladite durée maximale (Δtₘₐₓ) est prédéterminée de telle sorte que la valeur (V_{cell,n}) de tension entre lesdites bornes positive et négative (111, 112, 121, 122, 131, 142, 151, 152, 161, 162) de ladite cellule (110, 120, 130, 140, 150, 160) ne varie pas de plus de 1% en valeur absolue entre la première sous-étape de mesure (B1) et la deuxième sous-étape de mesure (B3).

2. Procédé selon la revendication 1, selon lequel, lors de la sous-étape de fermeture (B2), chaque branche électrique résistive (312, 313) est une branche électrique d'équilibrage d'une cellule (120).

3. Procédé selon la revendication 1 ou 2, comportant une étape de comparaison (C1) de la valeur (R_{I,n}) de résistance de ligne calculée avec une valeur seuil (RLₘₐₓ) de résistance électrique, et selon lequel l'état de ladite ligne électrique est déterminé (C2, C3) en fonction du résultat de ladite comparaison (C1).

4. Procédé selon la revendication 3, comportant en outre une étape de mesure (A1) d'une température (TLₙ) représentative de la température environnant ladite ligne électrique (21, 22), et selon lequel ladite valeur seuil (RLₘₐₓ) de résistance électrique est prédéterminée (A2) en fonction de cette température (TLₙ) représentative.

5. Procédé d'alerte sur l'état d'une ligne électrique (201, 202, 203, 204, 205, 206) reliant une cellule (110, 120, 130, 140, 150, 160) d'une batterie d'accumulateurs (100) à une unité de contrôle (300) de ladite batterie d'accumulateurs (100), ladite ligne électrique (201, 202, 203, 204, 205, 206) comprenant une première branche électrique (201, 202, 203, 204, 205) connectant une borne positive (111, 121, 131, 151, 161) de ladite cellule (110, 120, 130, 150, 160) à une première borne d'entrée (301, 302, 303, 304, 305) de ladite unité de contrôle (300) et une deuxième branche électrique (202, 203, 204, 205, 206) connectant une borne négative (112, 122, 142, 152, 162) de ladite cellule (110, 120, 140, 150, 160) à une deuxième borne d'entrée (302, 303, 304, 305, 306) de ladite unité de contrôle (300), ledit procédé d'alerte comportant :
- une étape de détermination de l'état de ladite ligne électrique (201, 202, 203, 204, 205, 206) en utilisant un procédé de détermination selon l'une des revendications 3 et 4 ; et
- une étape d'émission d'un signal d'alerte si la valeur (R_{I,n}) de résistance de ligne est supérieure à ladite valeur seuil (RL_{max,n}) de résistance électrique.

6. Unité de contrôle (300) des états de charge d'une pluralité de cellules (110, 120, 130, 140, 150, 160) d'une batterie d'accumulateurs (100), chaque cellule (110, 120, 130, 140, 150, 160) étant reliée à ladite unité de contrôle (300) par une ligne électrique (201, 202, 203, 204, 205, 206) comprenant une première branche électrique (201, 202, 203, 204, 205) connectant une borne positive (111, 121, 131, 151, 161) de ladite cellule (110, 120, 130, 150, 160) à une première borne d'entrée (301, 302, 303, 304, 305) de ladite unité de contrôle (300) et une deuxième branche électrique (202, 203, 204, 205, 206) connectant une borne négative (112, 122, 142, 152, 162) de ladite cellule (110, 120, 140, 150, 160) à une deuxième borne d'entrée (302, 303, 304, 305, 306) de ladite unité de contrôle (300), ladite unité de contrôle (30) étant conçue pour :
- calculer une valeur (R_{I,n}) de résistance de ligne de chaque ligne électrique (201, 202, 203, 204, 205, 206), en :
• mesurant, lorsque ladite cellule de batterie d'accumulateurs (100) n'est pas en charge ou en décharge, une première valeur (V_{m1,n}) de tension en circuit ouvert entre lesdites première et deuxième bornes d'entrée (301, 302, 303, 304, 305, 306) ;
• connectant, à un premier instant (t₁), lesdites première et deuxième bornes d'entrée (301, 302, 303, 304, 305, 306) par une branche électrique résistive (312, 313, 342, 343) dont la valeur (R_{bal,n}) de résistance électrique est prédéterminée ;
• mesurant, à un deuxième instant (t₂) séparé du premier instant (t₁) par une durée (Δt) comprise entre une durée minimale (Δtₘᵢₙ) et une durée maximale (Δtₘₐₓ) prédéterminées, une deuxième valeur (V_{m2,n}) de tension en circuit fermé entre lesdites première et deuxième borne d'entrée (301, 302, 303, 304, 305, 306) ; et,
• en estimant ladite valeur (R_{I,n}) de résistance de ligne de ladite ligne électrique (201, 202, 203, 204, 205, 206) en fonction de ladite valeur (R_{bal,n}) de résistance électrique prédéterminée et desdites première et deuxième valeurs (V_{m1,n}, V_{m2,n}) de tension mesurées ;
- déterminer l'état desdites lignes électriques (201, 202, 203, 204, 205, 206) en fonction desdites valeurs (R_{I,n}) de résistance de ligne calculées, ladite unité de contrôle (300) étant **caractérisée en ce que** :
• ladite durée minimale (Δtₘᵢₙ) est prédéterminée pour que la mesure de ladite deuxième valeur (V_{m2,n}) de tension soit réalisée en régime électrique statique, comprise entre 1 et 100 ms, et de préférence inférieure à 10 ms ; et,
• ladite durée maximale (Δtₘₐₓ) est prédéterminée de telle sorte que la valeur (V_{cell,n}) de tension entre lesdites bornes positive et négative (111, 112, 121, 122, 131, 142, 151, 152, 161, 162) de ladite cellule (110, 120, 130, 140, 150, 160) ne varie pas de plus de 1% en valeur absolue entre la mesure de ladite première valeur (V_{m1,n}) et ladite deuxième valeur (V_{m2,n}) de tension.

7. Système (100, 300) pour véhicule automobile électrique ou hybride comportant :
- une batterie d'accumulateurs (100) comprenant une pluralité de cellules (110, 120, 130, 140, 150, 160) ; et
- une unité de contrôle (300) de ladite batterie d'accumulateurs (100) conforme à la revendication 6.

8. Véhicule automobile électrique ou hybride comportant :
- un système (100, 300) conforme à la revendication 7 ; et
- un moteur électrique alimenté en courant (I_{HV}) par ladite batterie d'accumulateurs (100) dudit système (100, 300).

## Patentansprüche

1. Verfahren zur Bestimmung des Zustands einer elektrischen Leitung, die eine Zelle (110, 120, 130, 140, 150, 160) einer Akkumulatorbatterie (100) mit einer Überwachungseinheit (300) der Akkumulatorbatterie (100) verbindet, wobei die elektrische Leitung einen ersten elektrischen Zweig (201, 202, 203, 204, 205), der einen positiven Anschluss (111, 121, 131, 151, 161) der Zelle (110, 120, 130, 150, 160) mit einem ersten Eingangsanschluss (301, 302, 303, 304, 305) der Überwachungseinheit (300) verbindet, und einen zweiten elektrischen Zweig (202, 203, 204, 205, 206), der einen negativen Anschluss (112, 122, 142, 152, 162) der Zelle (110, 120, 140, 150, 160) mit einem zweiten Eingangsanschluss (302, 303, 304, 305, 306) der Überwachungseinheit (300) verbindet, beinhaltet, wobei das Verfahren Folgendes umfasst:
- einen Schritt des Berechnens (B) eines Leitungswiderstandswerts (R_{I,n}) der elektrischen Leitung (201, 202, 203, 204, 205, 206), beinhaltend:
- einen ersten Teilschritt des Messens (B1), wenn die Zelle der Akkumulatorbatterie (100) gerade nicht geladen oder entladen wird, eines ersten Spannungswerts (V_{m1,n}) bei offenem Kreis zwischen dem ersten und dem zweiten Eingangsanschluss (301, 302, 303, 304, 305, 306);
- einen Teilschritt des Schließens (B2) zu einem ersten Zeitpunkt (t₁), während dessen die Überwachungseinheit (300) den ersten und den zweiten Eingangsanschluss (301, 302, 303, 304, 305, 306) durch einen elektrischen Widerstandszweig (312, 313, 342, 343) verbindet, dessen elektrischer Widerstandswert (R_{bal,n}) vorbestimmt ist;
- einen zweiten Teilschritt des Messens (B3) zu einem zweiten Zeitpunkt (t₂), der von dem ersten Zeitpunkt (t₁) um eine Dauer (Δt), die zwischen einer vorbestimmten minimalen Dauer (Δtₘᵢₙ) und maximalen Dauer (Δtₘₐₓ) liegt, getrennt ist, eines zweiten Spannungswerts (V_{m2,n}) bei geschlossenem Kreis zwischen dem ersten und dem zweiten Eingangsanschluss (301, 302, 303, 304, 305, 306); und
- einen Teilschritt des Ermittelns (B4) des Leitungswiderstandswerts (R_{I,n}) der elektrischen Leitung (201, 202, 203, 204, 205, 206) in Abhängigkeit von dem vorbestimmten elektrischen Widerstandswert (R_{bal,n}) und dem gemessenen ersten und zweiten Spannungswert (V_{m1,n}, V_{m2,n}); und
- einen Schritt des Bestimmens (C) des Zustands der elektrischen Leitung (201, 202, 203, 204, 205, 206) in Abhängigkeit von dem berechneten Leitungswiderstandswert (R_{I,n}),
wobei das Bestimmungsverfahren **dadurch gekennzeichnet ist, dass**:
- die minimale Dauer (Δtₘᵢₙ) so vorbestimmt ist, dass der zweite Teilschritt des Messens (B3) in einem statischen elektrischen Zustand stattfindet, und zwischen 1 und 100 ms, vorzugsweise weniger als 10 ms beträgt; und
- die maximale Dauer (Δtₘₐₓ) so vorbestimmt ist, dass der Spannungswert (V_{cell,n}) zwischen dem positiven und negativen Anschluss (111, 112, 121, 122, 131, 142, 151, 152, 161, 162) der Zelle (110, 120, 130, 140, 150, 160) zwischen dem ersten Teilschritt des Messens (B1) und dem zweiten Teilschritt des Messens (B3) auf den Absolutwert bezogen um nicht mehr als 1 % variiert.

2. Verfahren nach Anspruch 1, wobei während des Teilschritts des Schließens (B2) jeder elektrische Widerstandszweig (312, 313) ein elektrischer Ausgleichszweig einer Zelle (120) ist.

3. Verfahren nach Anspruch 1 oder 2, das einen Schritt des Vergleichens (C1) des berechneten Leitungswiderstandswerts (R_{I,n}) mit einem elektrischen Widerstandsschwellenwert (RLₘₐₓ) umfasst, und wobei der Zustand der elektrischen Leitung in Abhängigkeit von dem Ergebnis des Vergleichs (C1) bestimmt wird (C2, C3).

4. Verfahren nach Anspruch 3, das ferner einen Schritt des Messens (A1) einer Temperatur (TLₙ), die für die Umgebungstemperatur der elektrischen Leitung (21, 22) repräsentativ ist, umfasst, und wobei der elektrische Widerstandsschwellenwert (RLₘₐₓ) in Abhängigkeit von dieser repräsentativen Temperatur (TLₙ) vorbestimmt wird (A2).

5. Warnverfahren in Bezug auf den Zustand einer elektrischen Leitung (201, 202, 203, 204, 205, 206), die eine Zelle (110, 120, 130, 140, 150, 160) einer Akkumulatorbatterie (100) mit einer Überwachungseinheit (300) der Akkumulatorbatterie (100) verbindet, wobei die elektrische Leitung (201, 202, 203, 204, 205, 206) einen ersten elektrischen Zweig (201, 202, 203, 204, 205), der einen positiven Anschluss (111, 121, 131, 151, 161) der Zelle (110, 120, 130, 150, 160) mit einem ersten Eingangsanschluss (301, 302, 303, 304, 305) der Überwachungseinheit (300) verbindet, und einen zweiten elektrischen Zweig (202, 203, 204, 205, 206), der einen negativen Anschluss (112, 122, 142, 152, 162) der Zelle (110, 120, 140, 150, 160) mit einem zweiten Eingangsanschluss (302, 303, 304, 305, 306) der Überwachungseinheit (300) verbindet, beinhaltet, wobei das Warnverfahren Folgendes umfasst:
- einen Schritt des Bestimmens des Zustands der elektrischen Leitung (201, 202, 203, 204, 205, 206) unter Verwendung eines Bestimmungsverfahrens nach einem der Ansprüche 3 und 4; und
- einen Schritt des Ausgebens eines Warnsignals, wenn der Leitungswiderstandswert (R_{I,n}) größer als der elektrische Widerstandsschwellenwert (RL_{max,n}) ist.

6. Überwachungseinheit (300) für die Ladezustände einer Vielzahl von Zellen (110, 120, 130, 140, 150, 160) einer Akkumulatorbatterie (100), wobei jede Zelle (110, 120, 130, 140, 150, 160) mit der Überwachungseinheit (300) durch eine elektrische Leitung (201, 202, 203, 204, 205, 206) verbunden ist, die einen ersten elektrischen Zweig (201, 202, 203, 204, 205), der einen positiven Anschluss (111, 121, 131, 151, 161) der Zelle (110, 120, 130, 150, 160) mit einem ersten Eingangsanschluss (301, 302, 303, 304, 305) der Überwachungseinheit (300) verbindet, und einen zweiten elektrischen Zweig (202, 203, 204, 205, 206), der einen negativen Anschluss (112, 122, 142, 152, 162) der Zelle (110, 120, 140, 150, 160) mit einem zweiten Eingangsanschluss (302, 303, 304, 305, 306) der Überwachungseinheit (300) verbindet, beinhaltet, wobei die Überwachungseinheit (30) für Folgendes ausgelegt ist:
- Berechnen eines Leitungswiderstandswerts (R_{I,n}) jeder elektrischen Leitung (201, 202, 203, 204, 205, 206) durch Folgendes:
• Messen, wenn die Zelle der Akkumulatorbatterie (100) gerade nicht geladen oder entladen wird, eines ersten Spannungswerts (V_{m1,n}) bei offenem Kreis zwischen dem ersten und dem zweiten Eingangsanschluss (301, 302, 303, 304, 305, 306);
• Verbinden, zu einem ersten Zeitpunkt (t₁), des ersten und des zweiten Eingangsanschlusses (301, 302, 303, 304, 305, 306) durch einen elektrischen Widerstandszweig (312, 313, 342, 343), dessen elektrischer Widerstandswert (R_{bal,n}) vorbestimmt ist;
• Messen, zu einem zweiten Zeitpunkt (t₂), der von dem ersten Zeitpunkt (t₁) um eine Dauer (Δt), die zwischen einer vorbestimmten minimalen Dauer (Δtₘᵢₙ) und maximalen Dauer (Δtₘₐₓ) liegt, getrennt ist, eines zweiten Spannungswerts (V_{m2,n}) bei geschlossenem Kreis zwischen dem ersten und dem zweiten Eingangsanschluss (301, 302, 303, 304, 305, 306); und
• Ermitteln des Leitungswiderstandswerts (R_{I,n}) der elektrischen Leitung (201, 202, 203, 204, 205, 206) in Abhängigkeit von dem vorbestimmten elektrischen Widerstandswert (R_{bal,n}) und dem gemessenen ersten und zweiten Spannungswert (V_{m1,n}, V_{m2,n});
- Bestimmen des Zustands der elektrischen Leitungen (201, 202, 203, 204, 205, 206) in Abhängigkeit von den berechneten Leitungswiderstandswerten (R_{I,n}),
wobei die Überwachungseinheit (300) **dadurch gekennzeichnet ist, dass**:
• die minimale Dauer (Δtₘᵢₙ) so vorbestimmt ist, dass das Messen des zweiten Spannungswerts (V_{m2,n}) in einem statischen elektrischen Zustand stattfindet, und zwischen 1 und 100 ms und vorzugsweise weniger als 10 ms beträgt; und
• die maximale Dauer (Δtₘₐₓ) so vorbestimmt ist, dass der Spannungswert (V_{cell,n}) zwischen dem positiven und negativen Anschluss (111, 112, 121, 122, 131, 142, 151, 152, 161, 162) der Zelle (110, 120, 130, 140, 150, 160) zwischen dem Messen des ersten Spannungswerts (V_{m1,n}) und des zweiten Spannungswerts (V_{m2,n}) auf den Absolutwert bezogen um nicht mehr als 1 % variiert.

7. System (100, 300) für ein Elektro- oder Hybridkraftfahrzeug, das Folgendes umfasst:
- eine Akkumulatorbatterie (100), die eine Vielzahl von Zellen (110, 120, 130, 140, 150, 160) beinhaltet; und
- eine Überwachungseinheit (300) für die Akkumulatorbatterie (100) nach Anspruch 6.

8. Elektro- oder Hybridkraftfahrzeug, das Folgendes umfasst:
- ein System (100, 300) nach Anspruch 7; und
- einen Elektromotor, der durch die Akkumulatorbatterie (100) des Systems (100, 300) mit Strom (I_{HV}) versorgt wird.

## Claims

1. Method for determining the state of an electrical line connecting a cell (110, 120, 130, 140, 150, 160) of a battery (100) to a monitoring unit (300) of said battery (100), said electrical line including a first electrical branch (201, 202, 203, 204, 205) connecting a positive terminal (111, 121, 131, 151, 161) of said cell (110, 120, 130, 150, 160) to a first input terminal (301, 302, 303, 304, 305) of said monitoring unit (300) and a second electrical branch (202, 203, 204, 205, 206) connecting a negative terminal (112, 122, 142, 152, 162) of said cell (110, 120, 140, 150, 160) to a second input terminal (302, 303, 304, 305, 306) of said monitoring unit (300), said method including:
- a step (B) of calculating a value (R_{I,n}) of the line resistance of said electrical line (201, 202, 203, 204, 205, 206) comprising:
- a first measurement substep (B1), when said cell of said battery (100) is not charging or discharging, of measuring an open circuit first voltage value (V_{m1,n}) between said first and second input terminals (301, 302, 303, 304, 305, 306);
- a closing substep (B2), at a first time (t₁), in which the monitoring unit (300) connects said first and second input terminals (301, 302, 303, 304, 305, 306) via a resistive electrical branch (312, 313, 342, 343) the electrical resistance value (R_{bal,n}) of which is predetermined;
- a second measurement substep (B3), at a second time (t₂) separated from said first time (t₁) by a duration (Δt) between a predetermined minimum duration (Δtₘᵢₙ) and a predetermined maximum duration (Δtₘₐₓ), of measuring a closed circuit second voltage value (V_{m2,n}) between said first and second input terminals (301, 302, 303, 304, 305, 306); and
- a substep (B4) of estimating said line resistance value (R_{I,n}) of said electrical line (201, 202, 203, 204, 205, 206) as a function of said predetermined electrical resistance value (R_{bal,n}) and said first and second measured voltage values (V_{m1,n}, V_{m2,n}); and
- a step (C) of determining the state of said electrical line (201, 202, 203, 204, 205, 206) as a function of said calculated line resistance value (R_{I,n}), said determination method being **characterized in that**:
- said minimum duration (Δtₘᵢₙ) is predetermined so that said second measurement substep (B3) is carried out under static electrical conditions, for between 1 and 100 ms, preferably less than 10 ms; and
- said maximum duration (Δtₘₐₓ) is predetermined so that the value (V_{cell,n}) of the voltage between said positive and negative terminals (111, 112, 121, 122, 131, 142, 151, 152, 161, 162) of said cell (110, 120, 130, 140, 150, 160) does not vary by more than 1% in absolute value between the first measurement substep (B1) and the second measurement substep (B3).

2. Method according to Claim 1, in which, during the closing substep (B2), each resistive electrical branch (312, 313) is a balancing electrical branch of a cell (120).

3. Method according to Claim 1 or 2, including a step (C1) of comparing the calculated line resistance value (R_{I,n}) with an electrical resistance threshold value (R_{Lmax}) and in which the state of said electrical line is determined (C2, C3) as a function of the result of said comparison (C1).

4. Method according to Claim 3, further including a step (A1) of measuring a temperature (TLₙ) representative of the ambient temperature of said electrical line (21, 22) and in which said electrical resistance threshold value (RLₘₐₓ) is predetermined (A2) as a function of that representative temperature (TLₙ).

5. Method for issuing an alert regarding the state of an electrical line (201, 202, 203, 204, 205, 206) connecting a cell (110, 120, 130, 140, 150, 160) of a battery (100) to a monitoring unit (300) of said battery (100), said electrical line (201, 202, 203, 204, 205, 206) including a first electrical branch (201, 202, 203, 204, 205) connecting a positive terminal (111, 121, 131, 151, 161) of said cell (110, 120, 130, 150, 160) to a first input terminal (301, 302, 303, 304, 305) of said monitoring unit (300) and a second electrical branch (202, 203, 204, 205, 206) connecting a negative terminal (112, 122, 142, 152, 162) of said cell (110, 120, 140, 150, 160) to a second input terminal (302, 303, 304, 305, 306) of said monitoring unit (300), said method of issuing an alert including:
- a step of determining the state of said electrical line (201, 202, 203, 204, 205, 206) using a determination method according to one of Claims 3 and 4; and
- a step of sending an alert signal if the line resistance value (R_{I,n}) is greater than said electrical resistance threshold value (RL_{max,n}).

6. Unit (300) for monitoring the states of charge of a plurality of cells (110, 120, 130, 140, 150, 160) of a battery (100), each cell (110, 120, 130, 140, 150, 160) being connected to said monitoring unit (300) by an electrical line (201, 202, 203, 204, 205, 206) including a first electrical branch (201, 202, 203, 204, 205) connecting a positive terminal (111, 121, 131, 151, 161) of said cell (110, 120, 130, 150, 160) to a first input terminal (301, 302, 303, 304, 305) of said monitoring unit (300) and a second electrical branch (202, 203, 204, 205, 206) connecting a negative terminal (112, 122, 142, 152, 162) of said cell (110, 120, 140, 150, 160) to a second input terminal (302, 303, 304, 305, 306) of said monitoring unit (300), said monitoring unit (30) being designed:
- to calculate a line resistance value (R_{I,n}) of each electrical line (201, 202, 203, 204, 205, 206), by:
• measuring, when said cell of said battery (100) is not charging or discharging, of an open circuit first voltage value (V_{m1,n}) between said first and second input terminals (301, 302, 303, 304, 305, 306);
• connecting, at a first time (t₁), said first and second input terminals (301, 302, 303, 304, 305, 306) via a resistive electrical branch (312, 313, 342, 343) the electrical resistance value (R_{bal,n}) of which is predetermined;
• measuring, at a second time (t₂) separated from the first time (t₁) by a duration (Δt) between a predetermined minimum duration (Δtₘᵢₙ) and a predetermined maximum duration (Δtₘₐₓ), a closed circuit second voltage value (V_{m2,n}) between said first and second input terminals (301, 302, 303, 304, 305, 306); and
• by estimating said line resistance value (R_{I,n}) of said electrical line (201, 202, 203, 204, 205, 206) as a function of said predetermined electrical resistance value (R_{bal,n}) and said first and second measured voltage values (V_{m1,n}, V_{m2,n});
- to determine the state of said electrical lines (201, 202, 203, 204, 205, 206) as a function of said calculated line resistance values (R_{I,n}),
said monitoring unit (300) being **characterized in that**:
• said minimum duration (Δtₘᵢₙ) is predetermined so that the measurement of said second voltage value (V_{m2,n}) is carried out under static electrical conditions, for between 1 and 100 ms, and preferably less than 10 ms; and
• said maximum duration (Δtₘₐₓ) is predetermined so that the value (V_{cell,n}) of the voltage between said positive and negative terminals (111, 112, 121, 122, 131, 142, 151, 152, 161, 162) of said cell (110, 120, 130, 140, 150, 160) does not vary by more than 1% in absolute value between the measurement of said first voltage value (V_{m1,n}) and the measurement of said second voltage value (V_{m2,n}).

7. System (100, 300) for electric or hybrid motor vehicles, including:
- a battery (100) comprising a plurality of cells (110, 120, 130, 140, 150, 160); and
- a monitoring unit (300) according to Claim 6 for said battery (100).

8. Electric or hybrid motor vehicle including:
- a system (100, 300) according to Claim 7; and
- an electric motor supplied with current (I_{HV}) by said battery (100) of said system (100, 300).
